# EUROPEAN PATENT APPLICATION

(11) **EP 2 793 393 A1**
(43) Date of publication of application: **22.10.2014**
(21) Application number: 13164614.3
(22) Date of filing: 21.04.2013
(51) Int. Cl.: H03F 1/32, H03F 3/183, H03G 5/16

(54) **Method and device for applying a transfer function on a signal received from a transducer**

(71) Applicant: Kornienkov, Alexey, 1190 Wien (AT)
(72) Inventor: Kornienkov, Alexey, 1190 Wien (AT)
(74) Representative: Weiser, Philipp Heribert

(57) **Abstract**

Method and electronic device for applying a transfer function, in particular a linearization, de-emphasis or emphasis, on a signal received from a transducer (1), wherein the device comprises at least one input (2), for the receipt of the signal, an analog circuit (3) comprising at least one filter (4) for signal processing, and an output (5) for the processed signal. The_device further comprises a microcontroller circuit which is coupled to at least one electronic part (6) of the analog circuit (3) and adapted to adjust the electric properties of at least the one electronic part (6).

## Description

The invention relates to a method for applying a transfer function, in particular a linearization, deemphasis or emphasis, on a signal received from a transducer. Further the invention relates to an electronic device for applying a transfer function, in particular a linearization, deemphasis or emphasis, on a signal received from a transducer, wherein the device comprises at least one input, for the receipt of the signal, an analog circuit comprising at least one filter for signal processing, and an output for the processed signal.

Analog circuits and methods for applying transfer functions on signals are well known in the art and can, for example, be used for processing audio signals in hi-fi components. Due to the rise of digital hi-fi equipment, analog processing methods have been reduced, but are still used in high quality audio systems to prevent the negative effects that an A/D conversion has on the sound quality. Analog audio processing is further being used for sound studio equipment or stage equipment.

For playback of long-playing records (as well as for audiocassette- and audiotape-playback) pre-amplifiers with a particular set of filters are used. The pre-amplifier converts a signal obtained from a pickup cartridge (transducer) to a corrected signal that is ready to be amplified for the listener. The Recording Industry Association of America (RIAA) has issued a set of recommendations as to parameters of such filters. These recommendations for LP playback are referred to as RIAA-equalization-curve.

With regard to the transfer function RIAA equalization defines transition points in three places: 75 µs, 318 µs and 3180 µs, which correspond to 2122 Hz, 500 Hz and 50 Hz. Also other equalization curves are well known to a person skilled in the art.

One problem of conventional pre-amp circuits is that the inductivity, resistance and/or capacity of the electronic parts within the pickup cartridge (transducer) alter the characteristics of the equalization. Therefore the ideal equalization curve of a particular pre-amp circuit can only be obtained with a specific type of a pickup cartridge. If the pickup cartridge gets replaced by a different model, the characteristic of the sound signal can be changed in an audible way, which is a problem especially for high quality audio equipment.

Amplifiers that take into account the inductivity and resistance of the pickup cartridge (transducer) for the design of the filter circuitry are known. This approach allows to minimize the number of parts in an amplifier, reduce noise and distortion, minimize interaction with cables and connectors, and to implement transimpedance topology of an amplifier. However, these amplifiers cannot automatically adjust themselves to various pickup cartridges available on the market, with varying resistance, inductance and/or capcity. Thus, there is a need for an amplifier implementing RIAA correction for LP playback that can be adjusted to varying pickup cartridges which might be used by the listener. Further there is a need for an amplifier implementing RIAA correction for LP playback that automatically adjusts to different pickup cartridges. Similar pre-amp circuitry could also be advantageously used in various devices which have to apply a transfer function on a signal received from a transducer, for example in the field of recording equipment, stage equipment or musical instruments such as electric guitars.

US 4,470,020 discloses a virtual ground pre-amplifier for application with magnetic phono cartridges such as moving coil, moving magnet, moving iron or similar type. The system utilizes circuit arrangements which compensate for the intrinsic inductance and dc resistance of the magnetic phono cartridge.

US 4,105,945 discloses a pre-amplifier which is intended to automatically adjust to different cartridges. Unfortunately the implementation of this approach is impractical, which inhibits the production of a commercial pre-amplifier based on the teachings of this patent.

The present invention aims to mitigate the problems of the prior art by providing a method and device for applying a transfer function on a signal from a transducer, wherein the transfer function can be easily adapted to different types of transducers.

According to the invention these and other advantages are achieved by the aforesaid method, which comprises the following steps: determining characteristics of the transducer; determining parameters required for a signal processing according to the transfer function; adjusting, using a microcontroller system, the electric properties of at least one electronic part of a filter of an analog circuit based on the determined parameters; and processing the signal according to the transfer function using the analog circuit. Advantageously, according to the invention, signal processing can automatically be adapted to different properties of the transducer. A high quality analog audio processing can be performed wherein no AD-conversion of the audio-signal has to be carried out. Nonetheless the analog signal processing can be controlled by digital means and the signal processing can be adjusted to varying transducers. The invention can be used for signals provided by transducers of different construction type, for example magnetic phono cartridges such as moving coil, moving magnet, moving iron or similar type.

According to a preferred embodiment, the characteristics of the transducer can be determined by a measurement using a measuring device which is connected to the microcontroller system. Thus changes of the electronic characteristics of the transducer can be automatically detected.

According to a further embodiment the characteristics of the transducer are determined by user selection and/or by reference to a database of known transducers.

In a preferred embodiment of the invention the determination of the required parameters can be performed by the microcontroller system. This allows for an automatic adjustment without the need for a user intervention.

According to a preferred embodiment of the invention the transfer function can correspond to a predefined equalization curve, in particular to the RIAA equalization curve for playback of vinyl records. Consequently the invention can be adapted to a wide range of existing and future standards on a broad field of applications known to the person skilled in the art.

According to a further aspect of the present invention the initially mentioned electronic device comprises a microcontroller circuit which is coupled to at least one electronic part of the analog circuit and adapted to adjust the electric properties of at least the one electronic part. This assures that digital components do not interfere with the analog components for high quality analog audio processing. The signal processing can be performed without an AD-conversion of the audio-signal. Analog signal processing can be controlled by digital means and can be easily adjusted to varying transducers.

According to a preferred embodiment of the invention the one or more electronic parts that are controlled by the microcontroller circuit can be selected from digital potentiometers, remotely-controlled potentiometers, variable capacitors and/or variable inductors. These electronic parts ensure simple electronic adjustment functions and can provide a good resolution with low tolerance errors.

In a further preferred embodiment an electronic part, which is controlled by a microcontroller circuit, can be arranged in a filter circuit of an active or passive pre-amplifier. In this way, well known and reliable circuit architecture can be used for the processing of the signal and the transfer function can easily be controlled.

According to a further embodiment of the invention the transfer function of the analog circuit can correspond to a linearization, deemphasis or emphasis according to a predefined and/or standardized equalization curve. Consequently the device can be used for equipment which uses a standardized frequency correction protocol, e.g. turntables, cassette decks, electronic instruments, etc.

According to a preferred embodiment of the invention, the microcontroller circuit can be connected to a measuring device for measuring the electronic properties of the transducer, particularly for measuring the electronic properties of a specific resistance, specific inductance and/or a specific capacitance of the transducer. With the measuring device the electronic device according to the invention can be automatically adapted to transducers with different properties and can therefore be used in connection with a broad range of existing pickup cartridges.

The invention will be further illustrated based on exemplary embodiments which will be described with reference to the accompanied drawings, wherein:
FIG.1 shows the frequency response characteristics of a filter according to the RIAA equalization curve for playback of vinyl records;
FIG. 2 is a circuit plan of an exemplary pre-amp, which is adjusted to a particular pickup cartridge;
FIG. 3 shows the frequency response of the filter stage of the pre-amp of FIG. 2;
FIG. 4 shows the frequency response of the filter stage of the pre-amp of FIG. 2, when the pickup has been changed to a different model without adapting the filter circuitry;
FIG. 5 shows the frequency response of the filter stage of the pre-amp of FIG. 2 equipped with the different pickup model, wherein the properties of the pre-amp have been adapted to match the different pickup model;
FIG. 6 shows the frequency response after a correction of the gain;
FIG. 7 shows a scatter plot illustrating the different properties of some customary pickup cartridges;
FIG. 8 shows a circuit plan of a preferred embodiment of the device according to the invention; and
FIG. 9 shows a further embodiment of the device according to the invention.

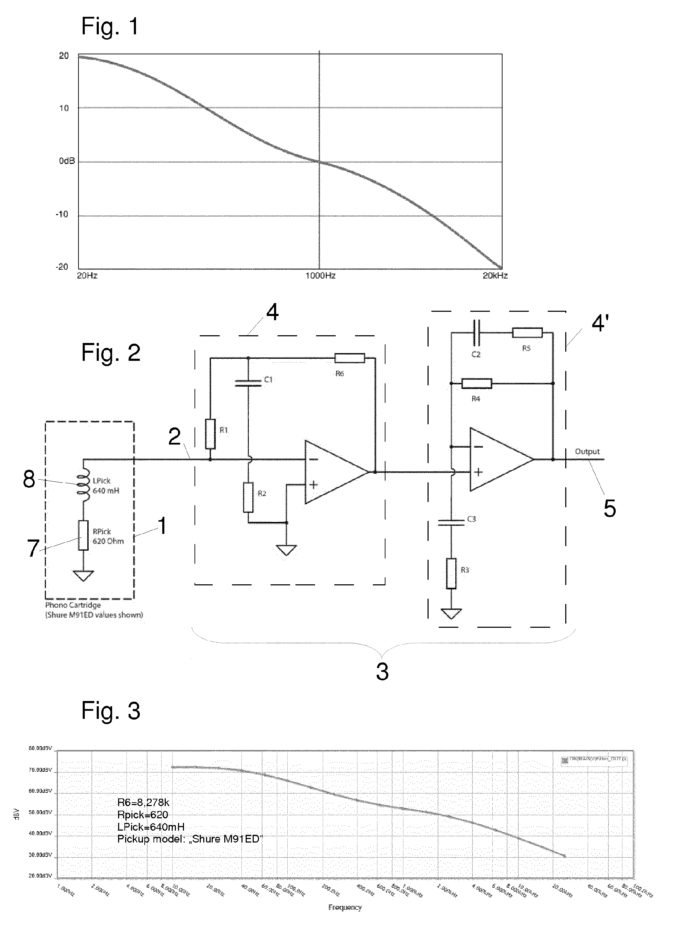

When recording a phonograph the low frequencies of the audio signal are reduced and the high frequencies are boosted according to a specified pre-emphasis curve. To obtain an unmodulated signal from the record at playback, the inverse transformation has to be applied according to a de-emphasis curve which corresponds to an inverse of the pre-emphasis curve that was used for the recording. The frequency response shown in FIG. 1 corresponds to the RIAA equalization curve according to a specification for the recording and playback of phonograph records (de-emphasis-curve), established by the Recording Industry Association of America (RIAA). The RIAA-curve defines transition points in three places, 75 µs, 318 µs and 3180 µs, which correspond to 2122 Hz, 500 Hz and 50 Hz. This RIAA-specification has been used as a de facto global industry standard for records since 1954. Similar transformation protocols (for example defining a different set of transition points) are being used for other analog recordings, e.g. for cassette tape records or audiotapes. Without limiting the scope of the invention, the further description will be given in the context of the RIAA-curve, but it lies within the capability of a skilled person to apply the teachings of this patent to other demands and standards.

In conventional techniques for phonograph playback the de-emphasis of the signal from the pickup is done by a pre-amplifier circuitry which usually consists of a series of filter stages. The filter stages can be constructed in numerous ways and can comprise passive filters (composed of passive components, i.e. resistors, capacitors and inductors), active filters (which also use active components such as bipolar junction transistors and field-effect transistors, operational amplifiers, and/or voltage/current amplification circuits), or any combination of such filter stages. Also circuits with tube amplifiers can be used, e.g. for high quality audio equipment.

As an example FIG. 2 shows a pre-amp circuit which could be used for the de-emphasis of a signal received from a phono cartridge, or generally a transducer 1. The transducer 1 comprises a specific resistance 7 and a specific inductance 8. In the example shown in FIG. 1 the specific resistance 7 (RPick) has a value of 620 Ω and the specific inductance 8 (LPick) is 640 mH. These values correspond to the Model M91ED Phonograph Cartridge, which is a product of Shure Microphones and Electronic Components, IL., USA. Further a specific capacitance (not shown) could be taken into account, e.g. representing the capacitance of the cable connecting the phono cartridge to the amplifier, as this is known to a person skilled in the art. Methods and circuits which take into account the capacitance of a pickup are discussed in US 4,470,020.

The signal is entered to the analog pre-amp circuit 3 at an input 2. The analog circuit 3 shown in FIG. 2 consists of two filter stages 4 and 4' connected in series, which each have an operational amplifier OP1 and OP2, respectively. To apply to the signal a transformation closely corresponding to the RIAA-curve-de-emphasis in conjunction with the Shure M91ED cartridge the following components values have been determined to be appropriate:

**Table 1 - Component values**

| **Component** | **Value** |
|---|---|
| R1 | 10 kΩ |
| R2 | 340 Ω |
| R3 | 200 Ω |
| R4 | 30 kΩ |
| R5 | 2,91 kΩ |
| R6 | 8,278 kΩ |
| C1 | 220nF |
| C2 | 100nF |
| C3 | 220µF |

The frequency response curve calculated at the output 5 of the circuitry in FIG. 2 is depicted in FIG. 3. The frequency response curve closely resembles to the RIAA-curve with the difference that the gain is about 53 dB higher than the RIAA-curve. The excess gain is constant throughout the entire frequency range and can therefore easily be corrected by a subsequent gain/attenuation stage (not shown).

It has to be pointed out that the component values (see table 1) have been selected to fit the specifications of the cartridge model being used (Shure M91ED) and that the frequency response would change if a pickup model with different specifications would be used. As an example the analog circuit 3 of FIG. 2 has also been analyzed in conjunction with a pickup model having a resistance of 475 Ω and a specific inductance of 45 mH. A commercial pickup cartridge having these characteristics is, e.g., available from GRADO Labs, NY., USA.

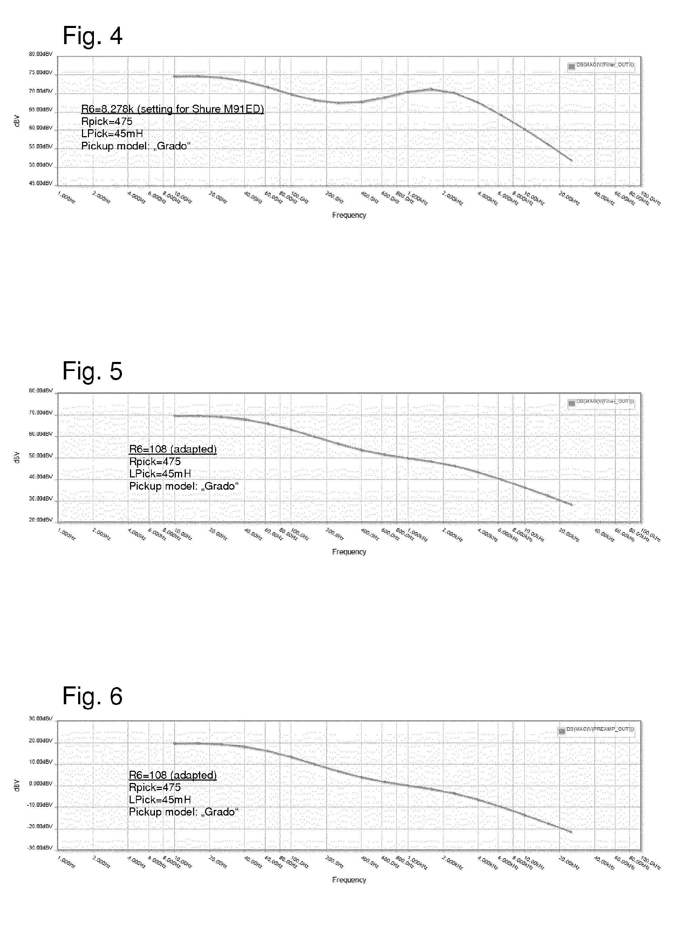

FIG. 4 shows the frequency response of the circuit of FIG. 2 with the component values according to table 1, but with the transducer 1 replaced by the GRADO-pickup cartridge (RPick=475Ω, LPick=45mH). As can easily be seen in FIG. 4 the curve now strongly differs from the RIAA-curve. Especially in the range between 400 Hz and 4 kHz - in which most frequencies of the human voice are located - an additional amplification peek can be recognized. This leads to an audible distortion of the audio signal which is inappropriate for high quality audio equipment. As can be easily verified by a person skilled in the art, the signal can be brought into perfect alliance with the RIAA-curve by simply changing the value of a single component, namely the Resistance R6, to a value of 108 Ω (instead of 8.278 kΩ used for the Shure M91ED pickup).

FIG. 5 shows the frequency response of the same System as in FIG. 4, wherein the value of R6 has been changed to 108 Ω. The frequency response is again corresponding to the RIAA-curve (having an additional constant gain of about 50 dB). In FIG. 6 the frequency response of fig 5 is represented after an attenuation of 50 dB has been applied to the signal. The curve now exactly corresponds to the RIAA curve, wherein the emphasis at 1,000 kHz is 0 dB.

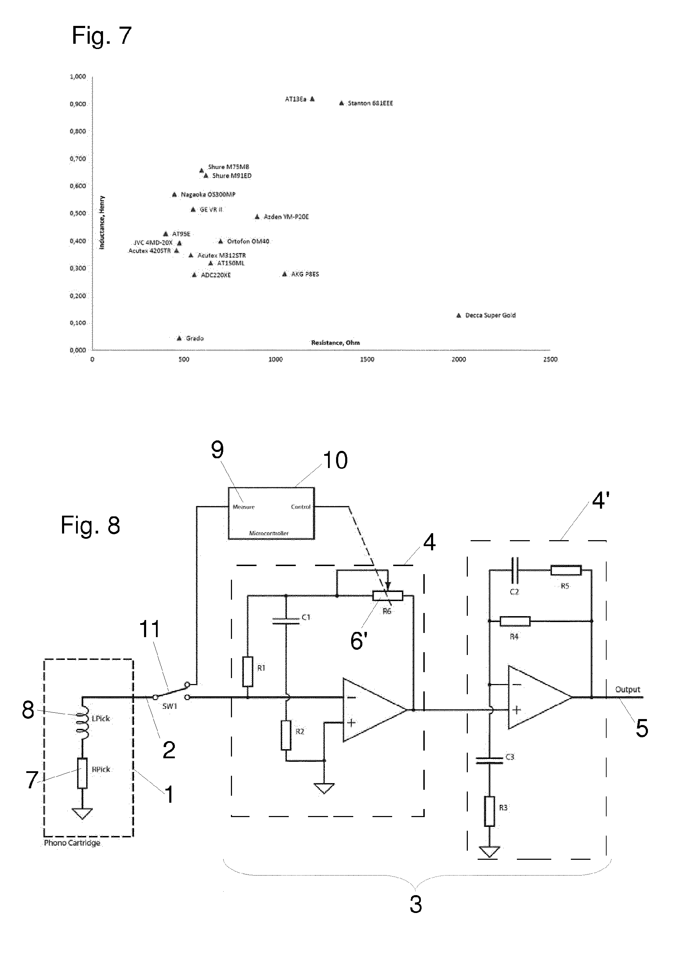

By choosing the right value for resistance R6 the pre-amplification circuit 3 can be adjusted to any pickup model with a different specific resistance and inductance. FIG. 7 shows a scatter plot of the properties of some customary pickup cartridges, wherein the abscissa represents the pickup resistance (ranging from 0 Ω to 2,500 Ω) and the ordinate represents the pickup inductance (ranging from 0 to 1.5 Henry). The diagram of FIG. 7 illustrates the broad range of different properties being used for pickup cartridges.

FIG. 8 shows a circuit plan according to an embodiment of the invention. The principal of operation of the circuit shown in FIG. 8 is similar to FIG. 2 and corresponding parts are denoted by the same reference numbers. The effects of the two filter circuits 4 and 4' are substantially the same as in FIG. 2, except for the resistance R6, which has been replaced by a potentiometer 6' which allows for an adjustment to the properties of the pickup resistance 7 and pickup inductance 8 of the transducer 1. According to the invention any potentiometer known in the art can be used. In the preferred embodiment shown in FIG. 8 the potentiometer is a digital potentiometer (also known as resistive DAC) which can be adjusted by digital input signals received from a microcontroller circuit 10. The microcontroller circuit 10 can be designed according to any techniques known in the art and is programmed to set the parameter of the digital potentiometer according to a specified protocol so that it fits the properties of the transducer 1.

Further the circuit in FIG. 8 comprises a measurement switch 11 which is arranged between the transducer 1 and the input 2 of the analog circuit 3. The measurement switch 11 allows for a connection of the transducer 1 to a measuring device 9 which can be connected to or is integrated into the microcontroller circuit 10. Preferably the measurement switch 11 can be actuated by the microcontroller circuit 10 so that the properties of the transducer 1 can be automatically measured by the microcontroller circuit 10 according to the specified measurement protocol being performed by the microcontroller circuit 10.

In a preferred embodiment of the invention the operation of the microcontroller circuit 10 comprises the following steps: determining characteristics of the transducer by actuating measurement switch 11 and measuring the properties of the transducer 1, determining the parameters required for a signal processing according to a specified transfer function and adjusting the electric properties of the potentiometer 6' based on the determined parameters to suit the properties of the cartridge that where measured. The measurement of the transducer properties can be either triggered by a specified event (e.g. during power-up or triggered by a user intervention) or it can be performed on a regular basis which, as an example, would also allow for the compensation of deviations arising from temperature differences during operation. The determination of the required parameters can for example be achieved by calculation or simulation or the properties can be set according to stored reverence values.

In FIG. 8 only one analog electronic part (potentiometer 6') is controlled by the microcontroller circuit 10. Nonetheless it lies within the ability of a person skilled in the art to implement similar circuits wherein the properties of more than one part can be adjusted by the microcontroller circuit. For example at the output 5 a further gain/attenuation stage (not shown) could be appended, to add a variable gain to the signal. The value of the gain could for example be adjusted by a further potentiometer which also could be controlled by the microcontroller circuit. Not only resistors, but also variable capacitors or variable inductors can be used as adjustable electronic parts. The particular circuit to be used and the specific electronic parts can be selected by a skilled person being familiar with the teachings of this patent.

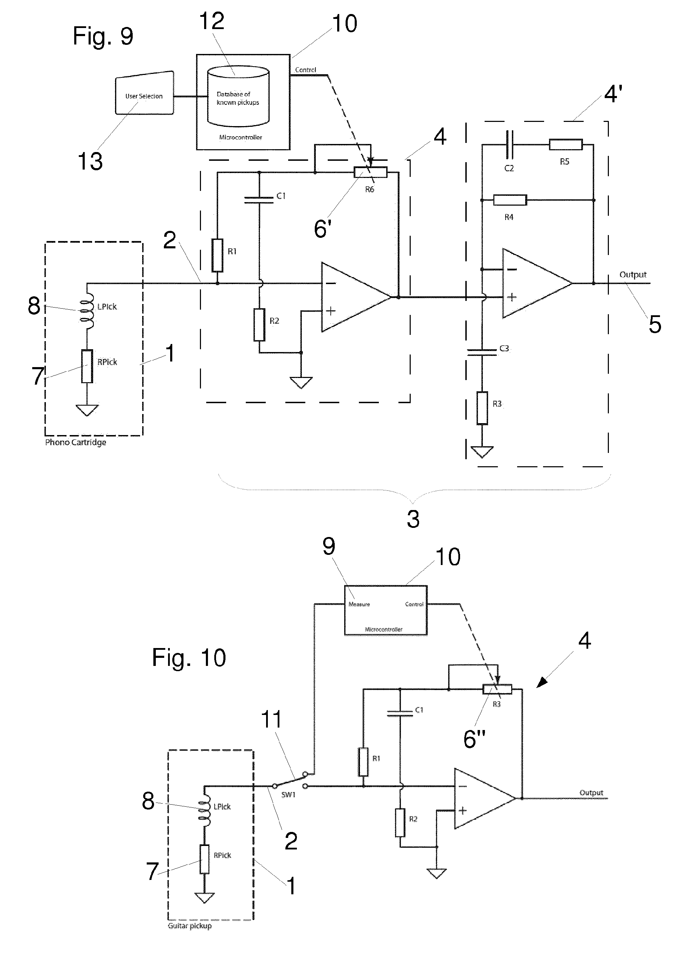

FIG. 9 shows a circuit plan according to a further embodiment of the invention. As compared to FIG. 8 the circuitry of transducer 1 and the filter circuits 4 and 4' remain essentially unchanged. The microcontroller circuit 10 comprises a database 12 of known pickup cartridges and is able to control the properties of the potentiometer 6' according to values read out from the database. The microcontroller circuit 10 of FIG. 9 does not comprise a measuring device so that changes of the settings have to be entered manually by the user if the pickup has been changed. For the interaction with the user the microcontroller circuit 10 can comprise or be connected to a user interface 13. The user selection can be entered by any suitable user interface 13 known in the art. Preferred examples of user interfaces include selector switches, key panels, key panels in combination with a display, touchscreen interfaces, etc. Further the user interface could be provided by an application running on a mobile device, e.g. a smartphone, which is able to communicate with the microcontroller system via an interconnecting cable, a wireless connection or the internet.

The invention has been described in connection with a preamp circuit for applying a de-emphasis on a signal received from a phonograph cartridge. Nonetheless the invention is not restricted to this exemplary application as the teachings of the invention could also be advantageously used for different methods and devices, such as recording equipment, stage equipment or musical instruments, e.g. electric guitars.

Fig. 10 shows such a further embodiment of the invention, wherein the transducer 1 is a pickup of an electric guitar which has a specific pickup resistance 7 and pickup inductance 8. The Filter circuit 4 shown in Fig. 10 is very similar to the embodiment depicted in Fig. 8 and similar parts are indicated with the identical reference numbers. By actuating a measurement switch 11 the properties of the transducer 1 can be measured by a measuring device 9 of a microcontroller circuit 10. Based on the results of the measurement the properties of an electronic part 6" (resistance R3) can be adjusted. By adjusting R3, the time constant formed by the capacitor C1 and parallel resistances of R1 and R3 can be made equal to the time constant formed by LPick and RPick. In this case, the amplifier would provide linear amplification of the signal from the pickup, provided the filter formed by C1 and R2 (which might be parasitic in nature) does not affect the desired bandwidth of the amplifier.

## Claims

1. Method for applying a transfer function, in particular a linearization, deemphasis or emphasis, on a signal received from a transducer, **characterized by** the following steps:
- determining characteristics of the transducer;
- determining parameters required for a signal processing according to the transfer function;
- adjusting, using a microcontroller system, the electric properties of at least one electronic part of a filter of an analog circuit based on the determined parameters; and
- processing the signal according to the transfer function using the analog circuit.

2. Method according to claim 1, wherein the characteristics of the transducer are determined by a measurement using a measuring device which is connected to the microcontroller system.

3. Method according to claim 1, wherein the characteristics of the transducer are determined by user selection and/or by reference to a database of known transducers.

4. Method according to any of the claims 1 to 3, wherein the determination of the required parameters is performed by the microcontroller system.

5. Method according to any of the claims 1 to 4, wherein the transfer function corresponds to a predefined equalization curve, in particular to the RIAA equalization curve for playback of vinyl records.

6. Electronic device for applying a transfer function, in particular a linearization, deemphasis or emphasis, on a signal received from a transducer (1), wherein the device comprises at least one input (2), for the receipt of the signal, an analog circuit (3) comprising at least one filter (4) for signal processing, and an output (5) for the processed signal, **characterized in that** the device further comprises a microcontroller circuit (10) which is coupled to at least one electronic part (6) of the analog circuit (3) and adapted to adjust the electric properties of at least the one electronic part (6).

7. Electronic device according to claim 6, wherein the one or more electronic parts (6) that are controlled by the microcontroller circuit, are selected from digital potentiometers, remotely-controlled potentiometers, variable capacitors and/or variable inductors.

8. Electronic device according to claim 6 or 7, wherein an electronic part (6), that is controlled by a microcontroller circuit (10), is arranged in a filter circuit (4) of an active or passive pre-amplifier.

9. Electronic device according to any of the claims 6 to 8, wherein the transfer function of the analog circuit corresponds to a linearization, deemphasis or emphasis according to a predefined and/or standardized equalization curve.

10. Electronic device according to any of the claims 6 to 9, wherein the microcontroller circuit is connected to a measuring device (9) for measuring the electronic properties of the transducer (1), particularly for measuring the electronic properties of a specific resistance (7), specific inductance (8) and/or a specific capacitance of the transducer.
